# EUROPEAN PATENT APPLICATION

(11) **EP 4 328 350 A1**
(43) Date of publication of application: **28.02.2024**
(21) Application number: 23192235.2
(22) Date of filing: 18.08.2023
(51) Int. Cl.: C23C 16/40, C23C 16/44, C23C 16/455, C23C 16/458

(54) **SUBSTRATE PROCESSING APPARATUS**

(30) Priority: 23.08.2022 US 202263373319 P; 27.07.2023 GR 20230100621
(71) Applicant: ASM IP Holding B.V., 1322 AP Almere (NL)
(72) Inventor: PARUI, Subir, 1322 AP Almere (NL); KNAEPEN, Werner, 1322 AP Almere (NL); PIERREUX, Dieter, 1322 AP Almere (NL); HOUBEN, Kelly, 1322 AP Almere (NL); TERHORST, Herbert, 1322 AP Almere (NL); OOSTERLAKEN, Theodorus G.M., 1322 AP Almere (NL); KARAGIANNIS, Angelos, 1322 AP Almere (NL)
(74) Representative: V.O.

(57) **Abstract**

A substrate processing apparatus configured to from a layer on a plurality of substrates is disclosed. Embodiments of the presently described substrate processing apparatus comprise a process chamber. The process chamber comprises process space for receiving a substrate boat arranged for holding the plurality of substrates. The substrate processing apparatus further comprise a gas delivery assembly comprising at least one gas injector; a gas exhaust assembly comprising two gas outlets. The two gas outlets are positioned at a distance on either side of the at least one gas injector.

## Description

### FIELD OF INVENTION

The present disclosure relates to a substrate processing apparatus. More specifically, it relates to a vertical furnace configured to form a layer on a plurality of substrates.

### BACKGROUND OF THE DISCLOSURE

In semiconductor industry, substrate processing apparatuses that are capable of processing a plurality of substrates continue to gain interest as they may provide improvement on throughput of the individual processes.

Moving forward in line with high volume manufacturing, the wafer load that these apparatuses may be able to handle may be increased. This effort may come forward with various challenges, one of which may relate to the within wafer non-uniformity (WIWNU) of the layer deposited on each substrate of the plurality of substrates. This may occur due to a decrease in pitch of the spacing between the substrates arranged in a substrate boat. Increased WIWNU may pose subsequent challenges for other processes such as, for example, film deposition, oxidation, diffusion, lithography or etch, in the semiconductor manufacturing process chain

There may be a need for improving within wafer non-uniformity.

### SUMMARY OF THE DISCLOSURE

This summary is provided to introduce a selection of concepts in a simplified form. These concepts are described in further detail in the detailed description of example embodiments of the disclosure below. This summary is not intended to identify key features or essential features of the claimed subject matter, nor is it intended to be used to limit the scope of the claimed subject matter

It may be an object of the present disclosure to provide a substrate processing apparatus for forming a uniform layer on a plurality of substrates.

The present disclosure relates to a substrate processing apparatus configured to form a layer on a plurality of substrates. The substrate processing apparatus may comprise a process chamber extending in a longitudinal direction and may comprise a process space. The apparatus may also comprise a substrate boat arranged for holding the plurality of substrates and being receivable in the process space. The apparatus may further comprise a gas delivery assembly. The gas delivery assembly may comprise at least one gas injector constructed and arranged to receive a first precursor gas and a second precursor gas and for providing the first precursor gas and the second precursor gas to the process space. The apparatus may also comprise a gas exhaust assembly. The gas exhaust assembly may comprise two gas outlets for removing a gas from the process space. The two gas outlets may be positioned at a distance on either side of the at least one gas injector.

The substrate processing apparatus according to embodiments of the present disclosure may allow for reducing thickness non-uniformity of the layer formed on the plurality of substrates. This may be thanks to the presence of the gas exhaust assembly comprising two gas outlets.

It may be an advantage of embodiments that flow of process gas across the process space may be enhanced during processing, thereby, increasing process yield and reducing precursor waste.

It may further be an advantage of embodiments that thanks to the reduced thickness non-uniformity, process yield of further processes in the semiconductor manufacturing may also be improved.

It may further be an advantage of embodiments that it may allow for processing the plurality of substrates at a time with reduced thickness uniformity, thereby improving process throughput.

It may be an advantage of embodiments that it may allow for improving the preventive maintenance cycle of the substrate processing apparatus thanks to the faster removal of unreacted process gas, by-products and/or intermediate products from the process chamber.

### BRIEF DESCRIPTION OF THE DRAWING FIGURES

It will be appreciated that elements in the figures are illustrated for simplicity and clarity and have not necessarily been drawn to scale. For example, the dimensions of some of the elements in the figures may be exaggerated relative to other elements to help improve understanding of illustrated embodiments of the present disclosure

Like reference numbers will be used for like elements in the drawings unless stated otherwise. Reference signs in the claims shall not be understood as limiting the scope.
Fig. 1: shows schematically a substrate processing apparatus according to embodiments of the present disclosure.
Fig. 2a to Fig. 2c: show schematically a top view of the process space bounded by the inner enclosure.
Fig. 3: shows a wafer map for thickness of the layer - (a) 170 slot boat with boat rotation of 2 rpm, (b) 170 slot boat with no boat rotation, (c) 120 slot boat with boat rotation of 2rpm and (d) 120 slot boat with no boat rotation.

### DETAILED DESCRIPTION OF EXEMPLARY EMBODIMENTS

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below.

The illustrations presented herein are not meant to be actual views of any particular material, structure, or device, but are merely idealized representations that are used to describe embodiments of the disclosure.

The particular implementations shown and described are illustrative of the invention and its best mode and are not intended to otherwise limit the scope of the aspects and implementations in any way. Indeed, for the sake of brevity, conventional manufacturing, connection, preparation, and other functional aspects of the system may not be described in detail. Furthermore, the connecting lines shown in the various figures are intended to represent exemplary functional relationships and/or physical couplings between the various elements. Many alternative or additional functional relationship or physical connections may be present in the practical system, and/or may be absent in some embodiments.

It is to be understood that the configurations and/or approaches described herein are exemplary in nature, and that these specific embodiments or examples are not to be considered in a limiting sense, because numerous variations are possible. The specific routines or methods described herein may represent one or more of any number of processing strategies. Thus, the various acts illustrated may be performed in the sequence illustrated, in other sequences, or omitted in some cases.

The subject matter of the present disclosure includes all novel and nonobvious combinations and sub-combinations of the various processes, systems, and configurations, and other features, functions, acts, and/or properties disclosed herein, as well as any and all equivalents thereof.

It is to be noticed that the term "comprising", as used herein, should not be interpreted as being restricted to the means listed thereafter. It does not exclude other elements or steps. Thus, it does not prevent one or more other steps, components, or features, or groups thereof from being present or being added. It is to be interpreted as specifying the presence of the stated features, steps or components as referred to.

Reference throughout the specification to "embodiments" in various places are not necessarily all referring to the same embodiment but may. Furthermore, the particular features, structures or characteristics maybe combined in any suitable manner, as would be apparent to one of the ordinary skill in the art from the disclosure, in one or more embodiments.

Reference throughout the specification to "some embodiments" means that a particular structure, feature step described in connection with these embodiments is included in some of the embodiments of the present invention. Thus, phrases appearing such as "in some embodiments" in different places throughout the specification are not necessarily referring to the same collection of embodiments but may.

As used herein and unless provided otherwise, the term "*uniformity*" may refer to having a reduced variation of layer thickness on the plurality of substrates.

As used herein and unless provided otherwise, the term "*load of substrates*" may refer to the total number of substrates in the substrate boat.

As used herein and unless provided otherwise, the term "*pitch*" may refer to the sum of the diameter and the spacing between the openings comprised in the gas outlet or those comprised in gas injector.

The term "*pitch*" may also refer to the sum of the spacing between neighboring substrates in the substrate boat and the thickness of one of the substrates.

The term "*substantially simultaneously*" may refer to the first precursor gas and the second precursor gas being provided to the gas injector, to a great extent, during overlapping time durations.

The disclosure will now be described by a detailed description of several embodiments of the disclosure. It is clear that other embodiments of the disclosure can be configured according to the knowledge of persons skilled in the art in the absence of departure from the technical teaching of the disclosure. The disclosure is limited only by the terms of the claims included herein.

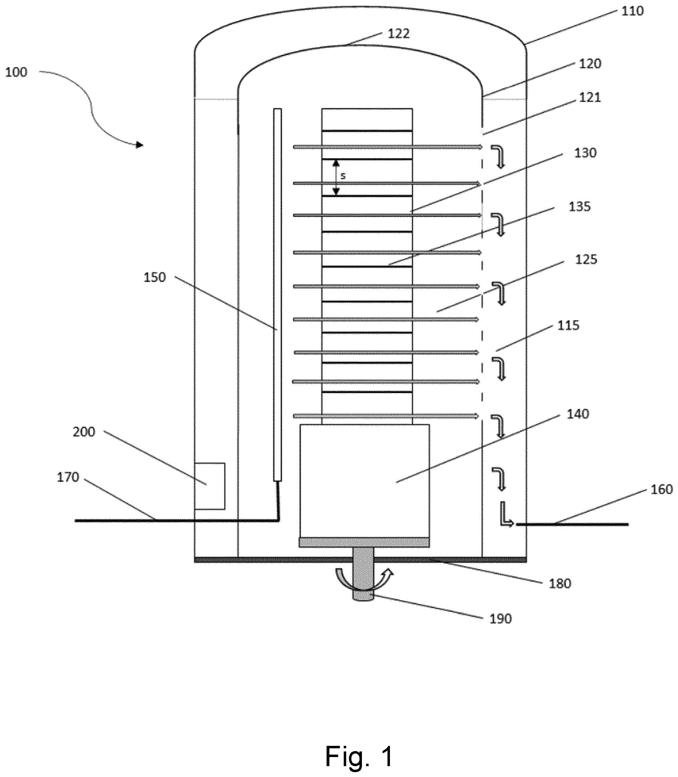

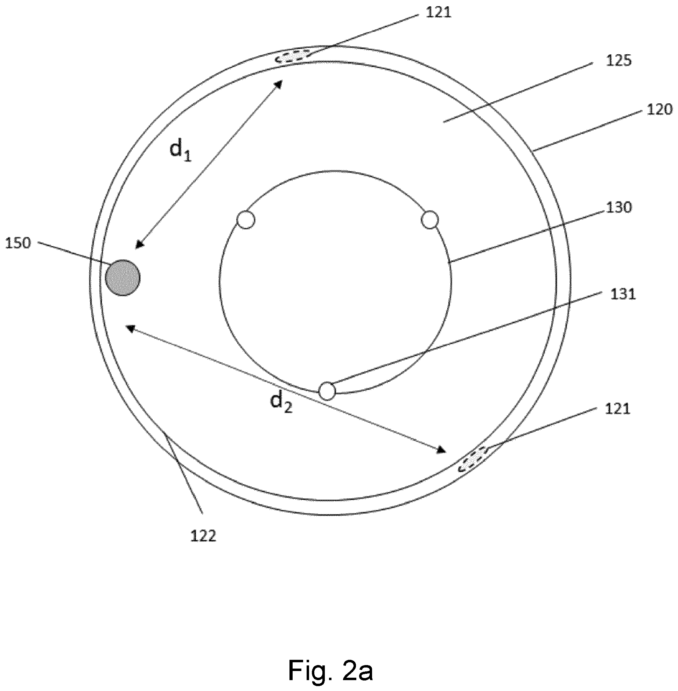

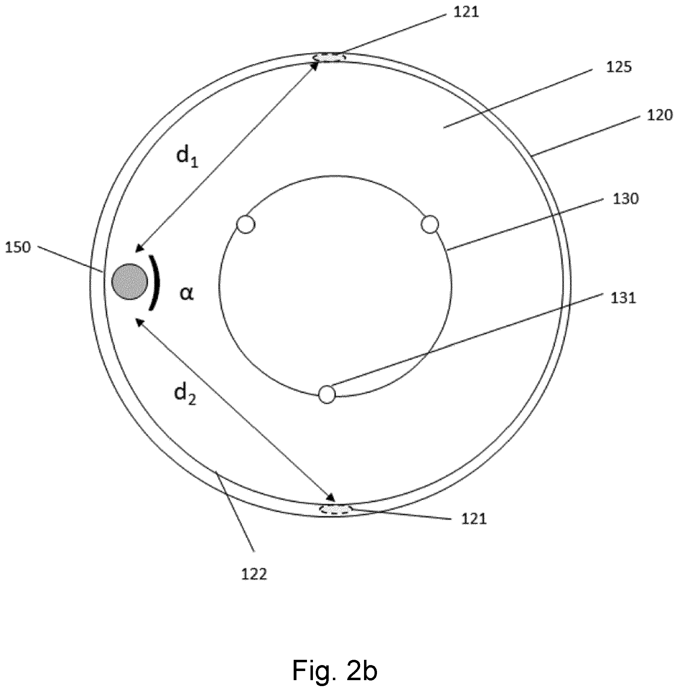

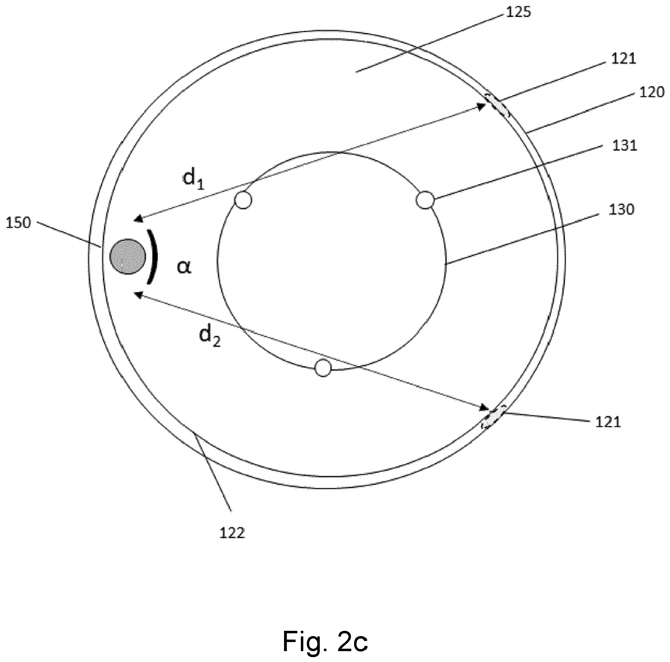

Fig. 1 shows schematically a substrate processing apparatus (100) according to embodiments of the present disclosure and Fig. 2 shows schematically a top view of the process space (125) bounded by the inner enclosure (120), the substrate boat (130) being receivable in the process space (125) and comprising boat rods (131).

The substrate processing apparatus (100) configured to form a layer on a plurality of substrates may comprise a process chamber (115). The process chamber (115) may extend longitudinally, in other words in a longitudinal direction. It is to be understood that when the process chamber (115) is comprised in a vertical furnace, the process chamber may then, extend in a vertical direction.

The process chamber (115) may comprise a process space (125). The process space (125) may be accessible through an opening at a lower end of the process chamber (115). The substrate processing apparatus (100) may further comprise a substrate boat (130) arranged for holding the plurality of substrates (135). The substrate boat (130) may be receivable in the process space (125). The substrate boat (130) may be receivable through the opening at the lower end of the process chamber (115). The process chamber (115) may be bounded by a process tube (110) that may be comprised in the substrate processing apparatus (100). The substrate processing apparatus (100) may further comprise a gas delivery assembly (170). The gas delivery assembly (170) may comprise at least one gas injector (150) that may be constructed and arranged to receive the process gas and for providing the process gas to the process space (125). The process gas may comprise a first precursor gas and a second precursor gas. Therefore, the at least one gas injector (150) constructed and arranged to receive the first precursor gas and the second precursor gas and may be suitable for providing the first precursor gas and the second precursor gas to the process space (125).

In some embodiments, the gas injector (150) may be constructed and arranged to receive the first precursor gas and the second precursor gas substantially simultaneously. In other words, the first precursor gas may be provided to the gas injector during a first duration of time and the second precursor gas may be provided to the gas injector during a second duration of time, whereby, the first duration of time and the second duration of time, in the gas injector, may overlap to a great extent. Thus, the first precursor gas and the second precursor gas may be present in the gas injector during the overlap. This may advantageously allow for mixing the first precursor gas and the second precursor gas already in the gas injector (150) before being provided into the process space (125) and thus, before contacting the surface of the substrates (135), on which a layer is to be formed. This may help to reduce the probability of occurrence of mixing disorders that may be influenced such as, for example, by the variation of the flow or of the partial pressure of the precursor gases in the process space (125) or that may be influenced by the arrangement of plurality of gas injectors (150) inside the process chamber (115) should the precursors be provided into the process space (125) simultaneously but by different gas injectors (150). Furthermore, the ability to have the precursors to already get mixed in the gas injector (150) may alleviate the need to use multiple gas injectors inside the process space (125)

In some embodiments the gas injector (150) may be constructed and arranged to receive the first precursor gas and the second precursor gas simultaneously. In other words, the first precursor gas and the second precursor gas may be provided to the gas injector at the same time.

In some embodiments, the gas injector (150) may be constructed and arranged to receive the first precursor gas and the second precursor gas partially simultaneously. In other words, the first precursor gas and the second precursor gas may be provided to the gas injector at differing times, whereby, the first duration and the second duration, in the gas injector, may overlap to a less extent.

In some embodiments, the gas injector (150) may be constructed and arranged to receive the first precursor gas and the second precursor gas alternatingly. In other words, the first precursor gas may be provided to the gas injector during a first duration of time and the second precursor gas may be provided to the gas injector during a second duration of time; whereby the first precursor gas and the second precursor gas may not be present in the gas injector at the same time so that their overlap in the gas injector does not take place. This may be advantageous in carrying out depositions in a step-wise manner, where continuous deposition may not possible or may not be advantageous for obtaining desired film characteristics.

In some embodiments, the first duration of time and the second duration of time may be different from one another.

In some embodiments, the first duration of time and the second duration of time may be the same.

The substrate processing apparatus (100) may further comprise a gas exhaust assembly (160). The gas exhaust assembly (160) may comprise two gas outlets for removing a gas from the process space (125). When the process gas comprises the first precursor gas and the second precursor gas, the two gas outlets may thus, the gas to be removed may then comprise a portion of the first precursor gas and a portion of the second precursor gas from the process space (125). The portion of the first precursor gas and the portion of the second precursor gas to be removed may comprise an unreacted portion of the first precursor gas and an unreacted portion of the second precursor gas. The portion of the first precursor gas and the portion of the second precursor gas to be removed may further comprise by-products and/or intermediate products formed as a result of the formation of the layer on the plurality of substrates.

The two gas outlets may be positioned at a distance (d₁, d₂) on either side of the gas injector (150). The two gas outlets may be provided in the inner enclosure (120). On either side of the gas injector (150) may be defined as on either side of a plane through the gas injector (150) and a center of the process chamber (115) and/or the inner enclosure (120). When the gas delivery assembly comprises two gas injectors on either side of the gas injector (150) may be defined as on either side of a plane through a point between the two gas injectors and a center of the process chamber (115) and/or the inner enclosure (120).

The substrate processing apparatus (100) may therefore, advantageously allow for a faster removal of the portion of the process gas from the process space (125). When the process gas comprises the first and the second precursor gas, then the substrate processing apparatus (100) may advantageously allow for a faster removal of the portion of the first precursor gas and the portion of the second precursor gas. Faster removal may thus, allow for reducing, in use, the residence time of by-products and/or intermediate products formed in the process space (125). Without wishing to be bound by theory, it may be stated that presence of by-products and/or intermediate products may disadvantageously lead to thickness non-uniformity across the surface of the substrates (135), on which the layer is to be formed. This may have to do with the fact that growth rate of the layer may be disadvantageously influenced by the presence of the by-products and/or intermediate products. Therefore, faster removal of the portion of the first precursor gas and the portion of the second precursor gas by the two gas outlets from the reaction space (125) may advantageously reduce the residence time of by-products and/or intermediate products, thereby reducing thickness non-uniformity across the surface of the substrates (135). Besides, faster removal of the portion of the first precursor gas and the portion of the second precursor gas by the two gas outlets from the process space (125) may advantageously help to keep a ratio of concentration of first precursor gas/ product concentration or a ratio of concentration of second precursor gas/ product concentration uniform over each substrate in the substrate boat. The product concentration may refer to the concentration of the by-product or the intermediate product.

In embodiments, the two gas outlets may be identical to one another. This may help to provide a balanced removal of the portion of the process gas from the process space (125).

In some embodiments, the gas injector (150) may be comprised in a set of gas injectors (not shown in the figures). In some embodiments, the set of gas injectors may comprise two gas injectors. Thus, in some embodiments, the gas delivery assembly (170) may comprise two gas injectors (150) for providing the first precursor gas and the second precursor gas to the process space (125). The two gas injectors may, in embodiments, be identical. The two gas injectors may provide the advantage of distributing the process gas flow equally into the process space (125), while keeping the total process gas flow to be the same as in the case for a single gas injector. This may provide the advantage of improving the preventive maintenance cycle of the gas injectors. Furthermore, equal distribution of the process gas into the two gas injectors may compensate for the increased need of the process gas in the process space (125) when the number of substrates arranged in the substrate boat is increased in alignment with high volume manufacturing.

The two gas injectors may be arranged in the process chamber (120) such that they may allow for equal exposure of each substrate of the plurality of substrates to the process gas. This may also be contribute building a balanced process gas flow path sweeping the surface of each substrate of the plurality of substrates within the spacing (s) and being directed towards the two gas outlets.

In some embodiments, the two gas injectors may be positioned at 180 ° with respect to one another in the process chamber (120). In these embodiments, the two gas outlets may also be positioned at 180 ° with respect to one another in the process chamber (120) and each of the two gas outlets being at 90 ° with each of the two gas injectors. This may be advantageous in creating a two-fold symmetry in providing the process gas into the process space (125), allowing for equal distribution of process gas over each substrate of the plurality of substrates and also in removing the process gas from the process space (125).

In some embodiments, the two gas outlets may be positioned at 180 ° with respect to one another in the process chamber (120); however, each of the two gas injectors may be positioned at an angle of less than 90 ° with each of the two gas outlets. In other words, each of the two gas injectors may be positioned closer to one of the gas outlets, while being positioned further away from the other gas outlet.

It is to be understood that, when the process gas comprises the first and the second precursor gas, then, the total flow of the first precursor gas together with the second precursor gas may be distributed equally into the two gas injectors, thereby also allowing to obtain the above-mentioned advantages.

In embodiments, the process space (125) may be defined by an inner enclosure (120) extending in the longitudinal direction and being closed on an upper portion (122). The inner enclosure (120) may comprise the two gas outlets. Each of the two gas outlets may comprise a plurality of openings (121) being collinearly arranged in the longitudinal direction. Thus, the plurality of openings comprised in each of the two gas outlets may extend vertically from a first-end near a lower section of the process space (125) towards a second-end near an upper section of the process space (125).

In other words, it may be stated that the plurality of openings (121), comprised in each of the two gas outlets, may be vertically spaced apart from one another in a longitudinal direction on the circumferential side of the inner enclosure (120). This may advantageously contribute to having a horizontal flow across the process space (125). This may further allow for improving the ratio of precursor concentration to intermediate product concentration or the ratio of precursor concentration to by-product concentration across the process space (125). Each opening of the plurality of openings (121) may be in the form of perforations such that they allow for forming sub-passages between the process space (125) and the process chamber (115).

In embodiments, the openings (121) may be substantially circular. This may provide the advantage in terms of easy manufacturing of the gas outlets. The gas outlets may be manufactured by laser cutting or by machining. In embodiments, the diameter and the pitch of the substantially circular openings may change along the height of the gas outlets. In some embodiments, the diameter and the pitch may increase from the first-end towards the second-end. In some embodiments, the diameter and the pitch may decrease from the first-end towards the second-end. The change in the diameter and in the pitch of the openings may allow for compensating for pressure differential that may be present inside the gas outlets. Furthermore, the change may also allow for compensating for how advanced the reaction is to obtain better distribution of precursor gas flow versus product formation.

In embodiments, the collinearly arranged openings (121) comprised in each of the two gas outlets may extend along the height of the substrate boat (130). This may allow for easier and faster emptying the process space (125) after the process gas reacts with the surface of each substrate of the plurality of substrates (135).

In embodiments, the collinearly arranged openings (121) may substantially coincide with the spacing (s) in between the substrates (135) that are arranged in the substrate boat (130). This may allow for the process gas entering into the process space (125) from the gas injector (150) to leave the process space (125) easily and faster in a uniform manner since the process gas may channel substantially directly following a flow path in a direction from the gas injector through the spacing (s) and to the collinearly arranged openings (121).In embodiments, the gas injector (150) may be positioned in the process space (125) being located in close proximity of the inner circumferential wall (122) of the inner enclosure (120).

In some embodiments the openings (121) of the gas outlet may be in the form of a slit. The slit may have an elongation orientation. The elongated orientation of the slit may be in a direction perpendicular to the longitudinal direction of the process chamber. The slit may have a width in a direction perpendicular to the longitudinal direction that is 1.5 to 10, 2 to 8, or 3 to 6 times the height of the slit in the longitudinal direction. In some embodiments a single slit may be applied as the gas outlet. The slit may enhance the gas to leave the process space (125) more easily and faster in a uniform manner.

In some embodiments, a distance (d₁) between the gas injector (150) and the first gas outlet may be different from a distance (d₂) between the gas injector (150) and the second gas outlet (Fig. 2a).

In some embodiments, each one of the two gas outlets may be positioned substantially equidistant from either side of the gas injector (150). The distance (d₁) between the gas injector (150) and the first gas outlet may than be equal to the distance (d₂) between the gas injector (150) and the second gas outlet (Fig. 2b, Fig. 2c).

In other words, it may be stated that in these embodiments, the two gas outlets may be positioned at an angle (α) of less than 180° with respect to the gas injector (150). This may allow for balanced removal of the portion of the process gas from the process space (125). When the process gas comprises the first and the second precursor gas, this may then advantageously allow for a balanced removal of the portion of the first precursor gas and the portion of the second precursor gas from the process space (125).

Furthermore, this may help to flatten the thickness profile of the layer across the surface of the substate (135), by overcoming non-uniform layer formation across the surface of the substrate (135). Non-uniform layer formation may lead such as, for example, to the thickness of the layer being thicker around a circumferential portion of the surface of the substrate compared to its central region or vice versa.

Non-uniform layer formation may be a result of the formation of by-products and/or intermediate products in the process space (125). A balanced removal of the portion of the first precursor gas and the portion of the second precursor gas from the process space (125) may therefore, lead to a reduction in the formation of by-products and/or intermediate products, thus overcoming non-uniform layer formation and non-uniform thickness of the layer across the surface of the substrates accordingly. Besides, a balanced removal of the portion of the first precursor gas and the portion of the second precursor gas by the two gas outlets from the reaction space (125) may also advantageously help to keep a ratio of concentration of first precursor gas/ product concentration and a ratio of concentration of second precursor gas/ product concentration uniform over each substrate of substrates in the substrate boat.

This semiconductor processing apparatus (100) may thus, make it advantageous to form the layer with improved thickness uniformity therefore, making it suitable for high volume manufacturing (HVM).

In some embodiments, each of the two gas outlets may be positioned in the process space (125) at an angle (α) of 90° with respect to the gas injector (150) (Fig. 2b). With the two gas outlets also being equidistant from the gas injector (150), this may indicate the two gas outlets being symmetrically positioned to one another within the process space (125).

In some embodiments, the two gas outlets may be positioned in the process space (125) at an angle (α) of less than 90° with respect to the gas injector (150) (Fig. 2c). With the two gas outlets being equidistant from the gas injector (150), this may indicate the two gas outlets being positioned towards an end point of the process gas flow path in the process space (125), the process gas flow path extending from the gas injector (150) towards the two gas outlets and through the spacing (s) between the substrates (135).

The exhaust gas assembly may, in embodiments, be connected to a pump. The pump may be operated to control the pressure in the process chamber (115).

The semiconductor processing apparatus (100) may comprise a door (180) that is movable in the longitudinal direction and configured for closing the process chamber (115) and further configured to support the substrate boat (130). The door (180) may comprise a drive (190) to allow for rotating the substate boat (130). The drive (190) and the substrate boat (130) may be separated by pedestal (140).

Thus, in embodiments, the substrate boat (130) may be rotatable inside the process space (125). This may help to improve thickness non-uniformity of the layer across the surface of the substrates (135).

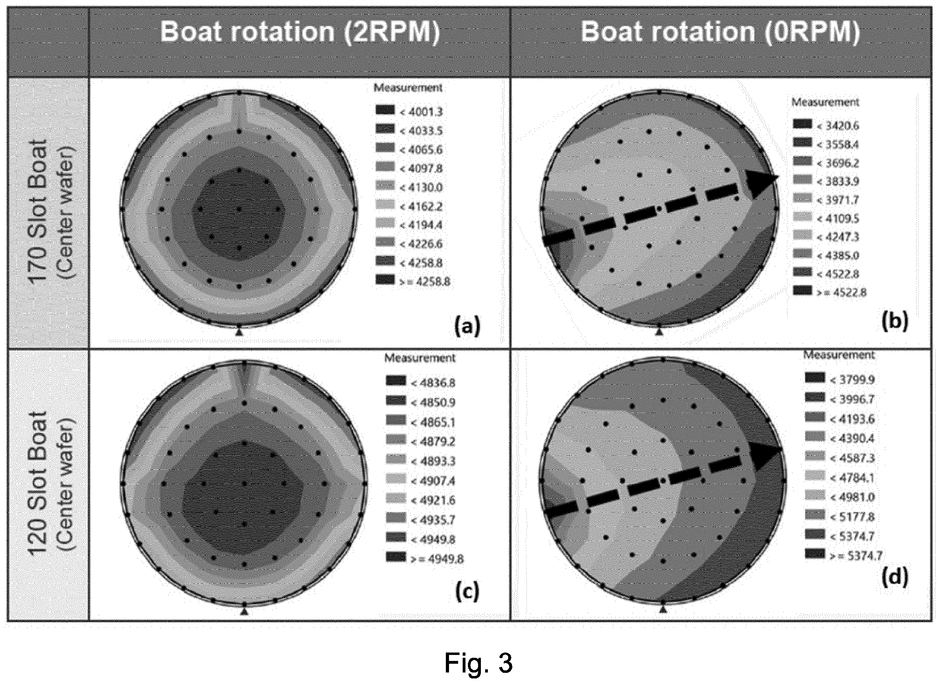

Fig. 3 shows a wafer map and indicating thickness variation as a function of boat rotation in comparison to an absence of boat rotation for a 120 slot boat and 170 slot boat, whereby one gas inlet and one gas outlet being opposite to the gas inlet is used, the gas inlet being a gas injector. The gas outlet was such that the inner enclosure (120) comprised openings (121) having the same dimension and being equally spaced and being distributed vertically along the height of the inner enclosure (121). In these experiments silicon oxide film is deposited at a process temperature of 665 °C and at a pressure of 500 mTorr, and by using TEOS and oxygen gas as the first precursor gas and second precursor gas, respectively and being provided through a gas injector. TEOS has been provided at a flowrate of 200 sccm and oxygen gas has been provided at a flowrate of 100 sccm. N₂ gas is provided to the process space (125) through the bottom of the inner enclosure (120) in order to avoid degassing of the process gas and to avoid reduction in its concentration. Furthermore, it may allow for keeping the lines clean and help for purging afterwards for the purpose of further cleaning of the lines. The wafer map is extracted from a wafer that was arranged in the center of the 120 slot boat and the 170 slot boat.

A presence of a horse-shoe shaped thickness variation is observed for both boats (Fig. 3b; Fig. 3d) in the absence of boat rotation. The horse-shoe shaped thickness variation is such that the thickness of the layer is the lowest in a region on the surface of the substrate that is surrounding and in the neighborhood of the gas injector (150), while it shows an increase in the direction of process gas flow path going from the gas injector to the gas outlet. As the thickness grows in the direction of the process gas flow path, the thickness profile curves sideways, thereby forming the horse-shoe shaped profile.

Boat rotation such as for example 2 rpm, on the other hand helps to improve the thickness profile to become substantially circular.

Therefore, the presence of boat rotation combined with a gas inlet and two gas outlets according to embodiments of the present disclosure may provide the advantage of further improving thickness uniformity across the substrate surface.

In embodiments, the gas injector (150) may comprise an injector tube extending in the longitudinal direction and may comprise a plurality of gas injection holes spaced apart vertically from one another. The gas injector tube may thus, extend vertically from a first-end near a lower section of the process space (125) towards a second-end near an upper section of the process space (125). The gas injection holes may be suitable for distributing the process gas into the process space (125). The process gas injection holes may extend along the height of the gas injector (150). In embodiments, the diameter of the process gas injection openings may be substantially the same. In some embodiments, the pitch of the process gas injection openings may be smaller towards its second-end compared to its first-end. This may allow for compensating for the pressure drop along the gas injector.

In embodiments, the gas injector (150) may extend in the longitudinal direction along the height of the substrate boat (130). This may allow for an equilibrated provision of the process gas into the process space (125) towards the plurality of substrates (135) arranged in the wafer boat (130) in the longitudinal direction. In embodiments, the process gas injection openings comprised in the injector tube may be constructed and arranged for injecting the process gas to the spacing (s) in between the substrates (135) arranged in the substrate boat (130).

In embodiments, the layer formed may comprise a dielectric material. The dielectric material may, in embodiments, be an oxide, nitride or carbide.

In some embodiments, the gas injector (150) may be constructed and arranged to receive, simultaneously, the first precursor gas and the second precursor gas. This may advantageously allow for mixing the first precursor gas and the second precursor gas already in the gas injector (150) before being provided into the process space (125) and thus, before contacting the surface of the substrates (135), on which a layer is to be formed. In embodiments, the gas injector (150) may therefore, be constructed and arranged to mix the first precursor gas and the second precursor gas.

The substrate processing apparatus (100) may further comprise a controller (200) being operably connected to the gas delivery assembly (170) and to the gas exhaust assembly (160). The controller (200) may be configured to execute instructions comprised in a non-transitory computer readable medium to cause the semiconductor processing apparatus (100) to form the layer on the plurality of substrates (135) by performing a deposition process. It is to be mentioned that the non-transitory computer readable medium does not include a mechanical switch. The deposition process may comprise providing the first precursor gas and the second precursor gas to the process space (125), thereby forming the layer. At the end of the deposition process, a portion of the first precursor gas and a portion of the second precursor gas may remain unmixed. Therefore, the deposition process may further comprise removing the portion of the first precursor gas and the portion of the second precursor gas from the process space (125). The substrate processing apparatus may thus, further comprise a heater (not shown in the figures) to adjust and maintain a process temperature during performing the deposition cycle. Furthermore, it may comprise a pressure controller (not shown in the figures) to adjust and maintain a process pressure during performing the deposition cycle. The heater and the pressure controller may be operably connected to the controller (200).

In embodiments, the substrate processing apparatus (100) may be a chemical vapor deposition (CVD) apparatus. In some embodiments, the CVD apparatus may be a Low Pressure Chemical Vapor Deposition (LPCVD) apparatus.

In an exemplary embodiment, the substrate processing apparatus being a LPCVD apparatus may thus, be used for forming a silicon oxide layer on the surface of the substrates (135). The first precursor gas may be tetraethyl-orthosilicate (TEOS) and the second precursor gas may be oxygen gas. Oxygen gas may allow for improving the deposition rate. By varying the concentration of the oxygen gas provided, the film properties of the silicon oxide layer to be formed may be adapted. The variation in the oxygen gas concentration may, for example, be advantageous in tuning the etch rate of the silicon oxide layer. During formation of the silicon oxide layer, an intermediate product such as, for example, tri-ethyl silane (TES) may form as TEOS breaks down. Upon reaction of TES with the oxygen gas, silicon oxide layer is formed. TEOS and oxygen gas may be supplied to the gas injector (150) simultaneously, thereby allowing mixing of TEOS and oxygen gas before contacting the surface of the substrates (135). It is to be mentioned that the formation of the silicon oxide layer may also be carried without the provision of the oxygen gas, whereby TES may itself lead to the formation of the silicon oxide layer.

TEOS may be provided at a flow rate in a range of 75 sccm to 300 sccm and oxygen as may be provided at a 1:1 ratio with TEOS and at a flow rate up to 300 sccm. The temperature in the process chamber (120) may be in a range between 600 °C to 700 °C and the pressure in the process chamber (120) may be in a range of 200 mTorr to 2000 mTorr. In some embodiments, the temperature in the process chamber (120) may be in a range between 650 °C to 680 °C and the pressure in the process chamber (120) may be in a range of 500 mTorr to 1000 mTorr.

The substrate processing apparatus according to embodiments of the present disclosure may thus be advantageous in providing horizontal flow for forming silicon oxide layer on the surface of the substrates, whereby tetraethyl orthosilicate (TEOS) and oxygen gas may be used. It may provide a faster removal of a portion of the TEOS and of a portion of oxygen gas, the portions pertaining to unreacted TEOS or unreacted oxygen gas or pertaining to by-products or intermediate products that may be formed. As TEOS breaks into TES, TES converts to silicon oxide by reacting with the oxygen gas. It is also to be mentioned that TES may also convert to silicon oxide in the absence of oxygen gas. Therefore, the more TEOS stays in the process space (125), the more it will break into TES, thus, changing the TEOS/TES ratio, which may influence the growth rate of the silicon oxide. This may consequently lead to thickness non-uniformity across the surface of the substrates.

The substrate processing apparatus may provide advantageously to keep the ratio of concentration TEOS/TES in the process space (125) uniform over the load of the substrates (135), thus, keeping a balanced growth rate across the surface of the substrates and thereby, helping to reduce thickness non-uniformity across the surface of the substrates (135).

In some embodiments, the gas injector (150) may be constructed and arranged to receive, alternatingly, the first precursor gas and the second precursor gas. This may be advantageous when forming the layer by atomic layer deposition. Thus, in embodiments, the substrate processing apparatus (100) may be an atomic layer deposition (ALD) apparatus. This may allow for forming the layer on the substrates with improved thickness control.

The substrate processing apparatus (100) may further comprise a controller (200) being operably connected to the gas delivery assembly (170) and to the gas exhaust assembly (160). The controller (200) may be configured to execute instructions comprised in a non-transitory computer readable medium to cause the semiconductor processing apparatus (100) to form the layer on the plurality of substrates (135) by sequentially repeating a deposition cycle. It is to be mentioned that the non-transitory computer readable medium does not include a mechanical switch. The deposition cycle may comprise providing the first precursor gas, to the process space (125), for a first pulse period and removing a portion of the first precursor gas from the process space (125). The deposition cycle may further comprise providing the second precursor gas, to the process space (125), for a second pulse period and removing a portion of the second precursor gas from the process space (125).

In embodiments, the removal of the portion of the first precursor gas and the removal of the portion of the second precursor gas may comprise providing an inert gas. The inert gas may, in embodiments, comprise substantially N₂.

In some embodiments, the inert gas may comprise substantially of one or more noble gases such, for example, He, Ne, Xe, Kr and Ar. In some embodiments, the inert gas may comprise substantially of at least one of N₂ and one or more of noble gases.

In embodiments, the removal of the portion of the first precursor gas may have a first duration to remove the portion of the first precursor gas from the process space (120), while the removal of the portion of the second precursor gas may have a second duration to remove the portion of the second precursor gas from the process space (120).

In embodiments, the provision of the inert gas that may be used for the removal of the portion of the first precursor gas and for the removal of the portion of the second precursor gas may also be done through the gas injector (150). This may advantageously allow for cleaning the gas injector (150) whereby the first precursor gas and the second precursor gas are removed from the gas injector. Furthermore, such cleaning of the gas injector (150) may help to reduce the probability of film deposition occurring in the gas injector (150) as the inner walls of the gas injector (150) is prevented from getting into subsequent and direct contact of the first precursor gas, which may have deposited on the inner walls of the gas injector (150), with the second precursor gas.

The embodiments of the present disclosure do not limit the scope of invention as these embodiments are defined by the claims appended herein and their legal equivalents. Any equivalent embodiments are intended to be within the scope of this invention. Modifications of the disclosure that are different from one another, in addition to those disclosed herein, may become apparent to those skilled in the art. Such modifications and the embodiments originating therefrom, are also intended to fall within the scope of the claims appended herein.

## Claims

1. A substrate processing apparatus configured to form a layer on a plurality of substrates, the substrate processing apparatus comprising:
a process chamber extending in a longitudinal direction and comprising a process space,
a substrate boat arranged for holding the plurality of substrates and being receivable in the process space,
a gas delivery assembly comprising at least one gas injector constructed and arranged to receive a first precursor gas and a second precursor gas and for providing the first precursor gas and the second precursor gas to the process space, and,
a gas exhaust assembly comprising two gas outlets for removing a gas from the process space, wherein, the two gas outlets are positioned at a distance on either side of the at least one gas injector.

2. The substrate processing apparatus according to claim 1, wherein each one of the two gas outlets is positioned substantially equidistant from either side of the gas injector.

3. The substrate processing apparatus according to claim 1 or 2, wherein the gas delivery assembly comprises two gas injectors for providing the first precursor gas and the second precursor gas to the process space.

4. The substrate processing apparatus according to any one of claims 1 to 3, wherein the gas injector is constructed and arranged to receive the first precursor gas and the second precursor gas substantially simultaneously or alternatingly.

5. The substrate processing apparatus according to any one of claims 1 to 4, wherein the process space is defined by an inner enclosure, the inner enclosure extending in the longitudinal direction, being closed on an upper portion and comprising the two gas outlets.

6. The substrate processing apparatus according to claim 5, wherein each of the two gas outlets comprises a plurality of openings being collinearly arranged in the longitudinal direction.

7. The substrate processing apparatus according to claim 6, wherein the collinearly arranged openings extend along the height of the substrate boat.

8. The substrate processing apparatus according to any one of claims 1 to 7, wherein the gas outlet comprises an opening which is in the form of a slit.

9. The substrate processing apparatus according to claim 8, wherein the slit is elongated in a direction perpendicular to the longitudinal direction of the process chamber.

10. The substrate processing apparatus according to claim 9, wherein the slit has a width in a direction perpendicular to the longitudinal direction that is 1.5 to 10 times the height of the slit in the longitudinal direction.

11. The substrate processing apparatus according to any one of claims 1 to 10, wherein the gas injector comprises an injector tube extending in the longitudinal direction and comprising a plurality of gas injection holes spaced apart vertically from one another.

12. The substrate processing apparatus according to any one of claims 1 to 11, wherein the gas injector extends in the longitudinal direction along the height of the substrate boat.

13. The substrate processing apparatus according to any one of claims 1 to 12, wherein the substrate boat is rotatable inside the process space.

14. The substrate processing apparatus according to any one of claims 1 to 13, wherein the gas injector is constructed and arranged to receive, substantially simultaneously, the first precursor gas and the second precursor gas and wherein the substrate processing apparatus further comprises a controller operably connected to the gas delivery assembly and to the gas exhaust assembly and
configured to execute instructions comprised in a non-transitory computer readable medium to cause the semiconductor processing apparatus to form the layer on the plurality of substrates by performing a deposition process, the process comprising:
providing the first precursor gas and the second precursor gas to the process space, thereby forming the layer, and,
removing a portion of the first precursor gas and a portion of the second precursor gas from the process space.

15. The substrate processing apparatus according to any one of claims 11 to 14, wherein the gas injector is constructed and arranged to mix the first precursor gas and the second precursor gas.

16. The substrate processing apparatus according to claim 11 or 12, or any one of claims 13 to 15 as dependent from claim 11 or 12, being a chemical vapor deposition apparatus.

17. The substrate processing apparatus according to any one of claims 1 to 16, wherein the gas injector is constructed and arranged to receive, alternatingly, the first precursor gas and the second precursor gas and wherein the substrate processing apparatus further comprises a controller operably connected to the gas delivery assembly and to the gas exhaust assembly and
configured for executing instructions comprised in a non-transitory computer readable medium to cause the semiconductor processing apparatus to form the layer on the plurality of substrates by sequentially repeating a deposition cycle, the cycle comprising:
providing the first precursor gas, to the process space, for a first pulse period,
removing a portion of the first precursor gas from the process space,
providing the second precursor gas, to the process space, for a second pulse period, and
removing a portion of the second precursor gas from the process space.

18. The substrate processing apparatus according to claim 17, being an atomic layer deposition apparatus.

19. The substrate processing apparatus according to any one of claims 1 to 18, wherein the layer formed comprises a dielectric material.
